(19) Europäisches Patentamt
European Patent Office
Office européen des brevets

(11) EP 3 989 689 A1

(12) **EUROPÄISCHE PATENTANMELDUNG**

(43) Veröffentlichungstag:
27.04.2022  Patentblatt 2022/17

(21) Anmeldenummer: 20203605.9

(22) Anmeldetag: **23.10.2020**

(51) Internationale Patentklassifikation (IPC):
*H05K 7/20* *(2006.01)*

(52) Gemeinsame Patentklassifikation (CPC):
**H05K 7/20909; H05K 7/20145; H05K 7/20509**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Kögler, Roman**
**90403 Nürnberg (DE)**
• **Namyslo, Lutz**
**91353 Hausen (DE)**
• **Schwinn, Thomas**
**91074 Herzogenaurach (DE)**

(54) **KÜHLKÖRPER-ANORDNUNG UND STROMRICHTERANORDNUNG**

(57)  Die Erfindung betrifft eine Kühlkörper-Anordnung (KKA) für mehrere Halbleiter-Bauelemente (T1,..,T6) umfassend einen ersten Kühlkörper (1) und einen zweiten Kühlkörper (2) mit jeweils einer Bauelemente-Seite (BS1,BS2) und einer mit Kühlrippen (F) bestückten Kühlrippenseite (KR1,KR2), welche derart hintereinander angeordnet sind, dass ein Kühlmedium (11) in einer Strömungsrichtung (10) zunächst durch Kühlkanäle (K1i), welche durch die Kühlrippen (F) des ersten Kühlkörpers (1) gebildet sind, und dann durch Kühlkanäle (K2i), welche durch die Kühlrippen (F) des zweiten Kühlkörpers (2) gebildet sind, strömt, wobei

- ein erster Einlassquerschnitt (Q1), welcher sich auf einer Einlassseite (E1) des ersten Kühlkörpers (1) durch Einzelquerschnitte (EQK1i) der zugehörigen Kühlkanäle (K1i), des ersten Kühlkörpers (1) zusammensetzt, mittels eines Abschottungsmittels, welches die Kühlkanäle (K1i) auf der Einlassseite (E1) des ersten Kühlkörpers (1) zumindest teilweise abdeckt, gegenüber
- einem zweiten Einlassquerschnitt (Q2), welcher sich auf einer Einlassseite (E2) des zweiten Kühlkörpers (2) durch Einzelquerschnitte (EQK2i) der zugehörigen Kühlkanäle (K2i) des zweiten Kühlkörpers (2) zusammensetzt, reduziert ist.

FIG 3

EP 3 989 689 A1

**Beschreibung**

Die Erfindung betrifft eine Kühlkörper-Anordnung für mehrere Halbleiter-Bauelemente, umfassend einen ersten Kühlkörper und einen zweiten Kühlkörper mit jeweils einer Bauelemente-Seite und einer mit Kühlrippen bestückten Kühlrippen-Seite, welche derart hintereinander angeordnet sind, dass ein Kühlmedium in einer Strömungsrichtung zunächst durch Kühlkanäle, welche durch die Kühlrippen des ersten Kühlkörpers gebildet sind, und dann durch Kühlkanäle, welche durch die Kühlrippen des zweiten Kühlkörpers gebildet sind, strömt.

Eine Kühlkörper-Anordnung mit mehr als zwei hintereinander angeordneten Kühlkörpern ist ebenso denkbar.

Des Weiteren betrifft die Erfindung eine Stromrichter-Anordnung zur Versorgung einer elektrischen Maschine, umfassend die eingangs genannte Kühlkörper-Anordnung.

Aus der Praxis ist es bekannt und üblich, zur Kühlung von Halbleiter-Bauelementen, Kühlkörper einzusetzen. Aus der EP 0 340 520 B1 ist eine Anordnung zur konvektiven Kühlung von Bauelementen bekannt, die einen Kühlkörper aufweist, der aus zwei übereinander angeordneten Teilen zusammengesetzt ist.

Aus fertigungstechnischen Gründen und aufgrund eines einfacheren konstruktiven Aufbaus und/oder einer platzsparenden Anordnung, beispielsweise in Stromrichter-Anordnungen, insbesondere eines Umrichters, werden die Halbleiter-Bauelemente, welche zur Ansteuerung eines Motors benötigt werden, oft auf einen gemeinsamen Kühlkörper zur Entwärmung angeordnet. Diese Halbleiter-Bauelemente sind in Bezug auf eine Richtung eines Kühlmedium-Flusses nacheinander platziert, wodurch eine thermische Reihenschaltung entsteht. Diese thermische Reihenschaltung führt zu einer abnehmenden Kühlwirkung, je weiter das jeweilige zu kühlende Halbleiter-Bauelement von einem Einlass des Kühlmediums entfernt ist.

Es ist Aufgabe der Erfindung eine Anordnung zur Kühlung von Halbleiter-Bauelementen bereitzustellen, bei welcher ein Kühlmedium auch bei weiter von einem Einlass entfernt liegenden zu kühlenden Bauteilen noch eine ausreichende Temperatur hat um damit eine ausreichende Kühlleistung für das vom Einlass weiter entfernte Bauteil zu erbringen.

Die eingangs genannte Aufgabe wird dadurch gelöst, dass ein erster Einlassquerschnitt, welcher sich auf einer Einlassseite des ersten Kühlkörpers durch Einzelquerschnitte der zugehörigen Kühlkanäle, des ersten Kühlkörpers zusammensetzt, mittels eines Abschottungsmittels, welches die Kühlkanäle auf der Einlassseite des ersten Kühlkörpers zumindest teilweise abdeckt, gegenüber einem zweiten Einlassquerschnitt, welcher sich auf einer Einlassseite des zweiten Kühlkörpers durch Einzelquerschnitte der zugehörigen Kühlkanäle des zweiten Kühlkörpers zusammensetzt, reduziert ist.

Da eine Parallelschaltung der beiden Kühlkörper aufgrund von Kompatibilitäten, z.B. bei bestehenden Umrichterreihen, mit einer definierten Kundenschnittstelle nicht möglich ist, sind die beiden Kühlkörper hintereinandergeschaltet. Der erste Kühlkörper könnte als der thermisch kühlere Kühlkörper bezeichnet werden und der zweite Kühlkörper kann als der thermisch wärmere Kühlkörper bezeichnet werden.

Erfindungsgemäß wird bei dem kühleren Kühlkörper durch eine thermische Teilentkopplung einzelner Kühlzwischenräume angewendet, dadurch wird seine Gesamtkühlleistung verschlechtert. Bei einem gleichen Volumenstrom, beispielsweise durch einen Lüfter bei einer forcierten Konvektion, erhöht sich ein Druck in einem Stauraum des Lüfters und der Volumenstrom in den verbleibenden "offenen" Kühlkanälen wird erhöht. Das aus dem kühleren Kühlkörper ausströmende Kühlmedium ist nun kühler als bei einer herkömmlichen Reihenschaltung, bei welchen kein Abschottungsmittel in dem ersten Kühlkörper eingesetzt ist. Demzufolge erhöht sich bei dem ersten Kühlkörper die statische Temperatur. Dies entspricht einer "Verschlechterung" der Entwärmung des mit beispielsweise einem Kunststoffkamm bestückten Kühlkörpers. Der Kunststoff muss die Kühlrippen nicht vollständig verschließen, auch Kamm-Teilunterbrechungen, Löcher sind denkbar.

Auch eine segmentale Teilabschottung eines Kühlkanals über beispielsweise konisch zulaufende Einlagen über die gesamte Rippenlänge ist denkbar.

Mit dieser Maßnahme kann man eine Anzahl von aktiven an der Kühlung beteiligten Kühlrippen beeinflussen.

Eine besonders vorteilhafte Weiterbildung der Kühlkörper-Anordnung sieht vor, dass zwischen dem ersten Kühlkörper und dem zweiten Kühlkörper ein Zwischenraum angeordnet ist, welcher mittels einer Abdeckung abgedeckt ist, wobei der Zwischenraum und die Abdeckung eine Verwirbelungskammer bilden.

Einzelne Ströme aus den Kühlkanälen des ersten Kühlkörpers können nun in dem Zwischenraum verwirbeln und zu neuen Strömen für den zweiten Kühlkörper, in die, in der Regel gänzlich offenen, Kühlkanäle einströmen. Der Zwischenraum mit seiner Abdeckung fungiert als eine Art Diffusor für das Kühlmedium. Um dem zweiten in Reihe geschalteten Kühlkörper das aus dem ersten Kühlkörper ausströmende Kühlmedium gleichmäßig auf alle Kühlrippen bzw. Kühlkanäle zur Verfügung zu stellen, wird der Vorraum benötigt, der die Verwirbelung und gleichmäßige Verteilung des Kühlmediums sicherstellt.

In einer weiteren vorteilhaften Ausgestaltung ist das Abschottungsmittel als ein Kamm zum Einstecken in die Einlassseite des ersten Kühlkörpers ausgestaltet.

In dem Zwischenraum werden für eine verbesserte Verwirbelung Verwirbelungs- und/oder Leitelemente angeordnet.

Durch Einbringen eines Kunststoffteils zwischen den beiden Kühlkörpern kann der Zwischenraum abgedeckt werden. Dieser Zwischenraum dient zur gleichmäßigen Verteilung des Kühlmediums auf die anderen Kühlkanäle des zweiten Kühlkörpers. Das Kunststoffteil kann in einer vorteilhaften Ausführung so gestaltet sein, dass es intern eine Struktur aufweist, die die notwendige optimale Verwirbelung und Kühlmittelmedium-Umlenkung übernimmt. Verwirbelungselemente könnten beispielsweise als Strömungsleitbleche oder tragflächenförmig oder wie ein Spoiler, ausgestaltet sein.

Die eingangs genannte Aufgabe wird ebenso durch eine Stromrichteranordnung zur Versorgung einer elektrischen Maschine gelöst. Die Stromrichteranordnung umfasst dabei eine Kühlkörper-Anordnung für mehrere Halbleiter-Bauelemente umfassend, einen ersten Kühlkörper und einen zweiten Kühlkörper mit jeweils einer Bauelemente-Seite und einer mit Kühlrippen bestückten Kühlrippenseite, welche derart hintereinander angeordnet sind, dass ein Kühlmedium in einer Strömungsrichtung zunächst durch die Kühlkanäle, welche durch die Kühlrippen des ersten Kühlkörpers gebildet sind, und dann durch die Kühlkanäle, welche durch die Kühlrippen des zweiten Kühlkörpers gebildet sind, strömt. Dabei wird ein erster Einlassquerschnitt, welcher sich auf einer Einlassseite des ersten Kühlkörpers durch Einzelquerschnitte der zugehörigen Kühlkanäle, des ersten Kühlkörpers zusammensetzt, mittels eines Abschottungsmittels, welches die Kühlkanäle, auf der Einlassseite des ersten Kühlkörpers zumindest teilweise abdeckt, gegenüber einem zweiten Einlassquerschnitt, welcher sich auf einer Einlassseite des zweiten Kühlkörpers durch Einzelquerschnitte der zugehörigen Kühlkanäle des zweiten Kühlkörpers zusammensetzt, reduziert.

Um die Entwärmung der Anordnung weiterhin zu verbessern, ist zwischen dem ersten Kühlkörper und dem zweiten Kühlkörper ein Zwischenraum angeordnet, welcher mittels einer Abdeckung abgedeckt ist, wobei der Zwischenraum und die Abdeckung eine Verwirbelungskammer bilden.

Insbesondere in Bezug auf Umrichter für die Steuerung von elektrischen Maschinen ist die Stromrichter-Anordnung vorgesehen zum senkrechten Einbau in einen Schaltschrank, wobei eine Längsachse der Kühlkörper-Anordnung vertikal angeordnet ist und damit die Strömungsrichtung durch die Stromrichter-Anordnung parallel zur Längsachse entsteht und ein Einlass für ein Kühlmedium unten an der Einlassseite des ersten Körpers angeordnet ist und ein Auslass für das Kühlmedium oben über der der Einlassseite des zweiten Kühlkörpers gegenüberliegenden Auslassseite angeordnet ist.

Mit Vorteil wird nun für derart bautechnisch gestaltete Stromrichter-Anordnungen kein zusätzlicher Bypass mehr für die Kühlkörper-Anordnung benötigt, dieser zusätzliche Bypass würde nur das restliche zur Verfügung stehende Gerätevolumen, welches besser zur Unterbringung elektronischer und mechanischer Komponenten benötigt wird, reduzieren. Folglich besteht der notwendige Bauraum für weitere Gerätebauteile, wie Sicherung, Zwischenkreiskondensatoren nun zur Verfügung.

Die zuvor verwendeten preisintensiven teureren Bypass-Bauteile werden nicht mehr benötigt und ein Geräteaufbau einer Stromrichter-Anordnung konstruktiv, sowie montageseitig vereinfacht. In Abhängigkeit von der Ausführung des Abschottungsmittels bzw. Einschubkammes (Anzahl der verschlossenen Kühlkanäle) und des zwischen den Kühlkörpern vorhandenen Stauraumes, kann die Entwärmung der beiden in Reihe geschalteten Kühlkörper so optimiert werden, dass beide Kühlkörper annähernd eine gleiche Temperatur im Betrieb erreichen. Dies führt zu einer Erhöhung einer Lebensdauer der Stromrichter-Anordnung, da ohne die oben genannten Maßnahmen der thermisch wärmere Kühlkörper lebensdauerbestimmend für die Halbleiter-Bauelemente ist. Auch eine Kostenreduktion aufgrund des Einsatzes gegebenenfalls kleinerer Leistungshalbleiter wäre denkbar, da die Halbleiterclips nicht mehr auf den heißeren im Luftkanal sekundär durchströmenden Kühlkörper ausgelegt werden müssen.

Die Zeichnung zeigt ein Ausführungsbeispiel, wobei die

FIG 1     eine Kühlkörper-Anordnung zum Kühlen von Halbleiterbauteilen zeigt,

FIG 2     die Kühlkörper-Anordnung in einer anderen perspektivischen Ansicht mit einer Draufsicht auf eine Kühlrippenseite,

FIG 3     die aus FIG 2 bekannte Kühlkörper-Anordnung mit Augenmerk auf einen Zwischenraum,

FIG 4     eine Abdeckung für den Zwischenraum,

FIG 5     die Abdeckung aus FIG 4 in einer anderen perspektivischen Darstellung,

FIG 6     einen Kamm als Abschottungsmittel,

FIG 7     eine Verdeutlichung der effektiven Einlassquerschnitte,

FIG 8     eine Verdeutlichung der Verwirbelung von Strömungslinien in dem Zwischenraum und

FIG 9     eine Stromrichter-Anordnung in einem Schaltschrank.

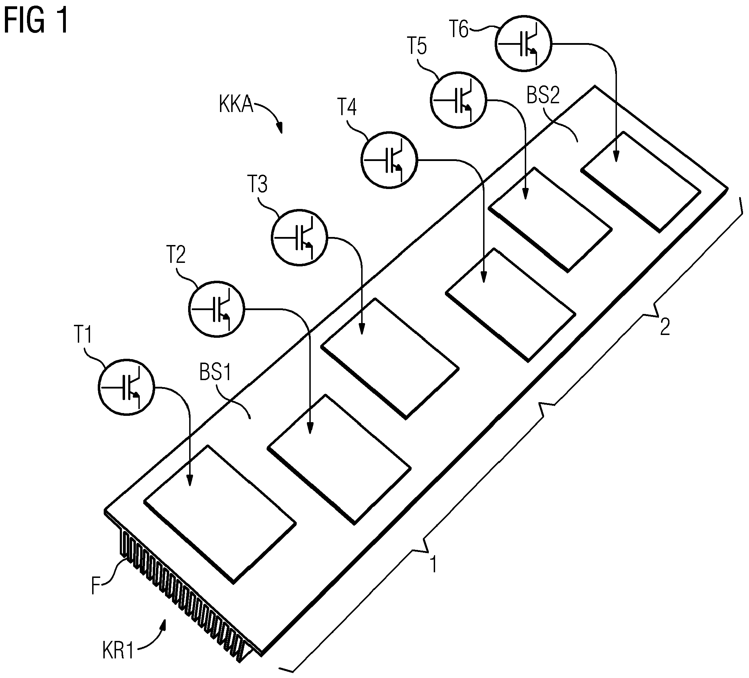

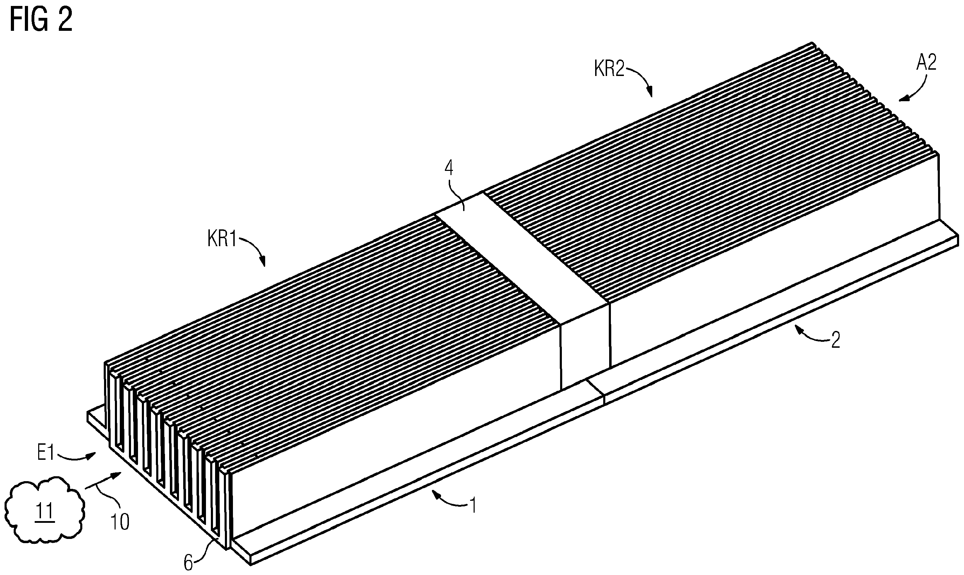

Gemäß FIG 1 ist eine Kühlkörper-Anordnung KKA für mehrere Halbleiter-Bauelemente T1,...,T6 gezeigt. Die Kühlkörper-Anordnung KKA umfasst einen ersten Kühlkörper 1 und einen zweiten Kühlkörper 2 mit jeweils einer Bauelemente-Seite BS1,BS2 auf welchen die Halbleiter-Bauelemente T1,...,T6 zur Kühlung platziert werden können. Den Bauelemente-Seiten BS1,BS2 liegt jeweils eine mit Kühlrippen F bestückte Kühlrippenseite KR1,KR2 gegenüber. Die Kühlrippen F sind derart hintereinander angeordnet, dass ein Kühlmedium 11 in einer Strömungsrichtung 10 gemäß FIG 2 zunächst durch die Kühlkanäle K1i, welche durch die Kühlrippen F des ersten Kühlkörpers 1 gebildet sind, und dann durch die Kühlkanäle K2i, welche durch die Kühlrippen F des zweiten Kühlkörpers 2 gebildet sind, strömt.

FIG 2 zeigt die Kühlkörper-Anordnung KK1 mit Blick auf die Kühlrippenseiten KR1,KR2.

Das Kühlmedium 11 kann an einer ersten Einlassseite E1 in die Kühlkörper-Anordnung KKA eintreten und über eine Auslassseite A2 des zweiten Kühlkörpers 2 wieder austreten. Eine Abdeckung 4 verbindet die beiden Kühlkörper 1,2 strömungstechnisch miteinander. Mittels eines Kammes 6 wird ein Querschnitt der ersten Einlassseite E1 verkleinert.

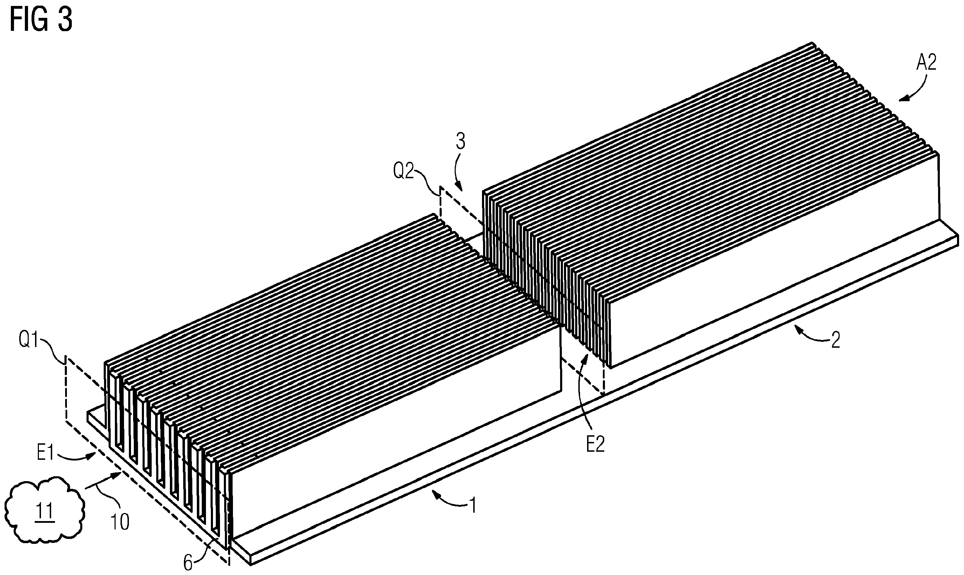

FIG 3 zeigt wie sich ein erster Einlassquerschnitt Q1, welcher sich auf der Einlassseite E1 des ersten Kühlkörpers 1 durch Einzelquerschnitte EQK1i der zugehörigen Kühlkanäle K1i, des ersten Kühlkörpers, zusammensetzt. Mittels des Kammes 6, welcher die Kühlkanäle K1i auf der Einlassseite E1 des ersten Kühlkörpers 1 zumindest teilweise abdeckt, wird gegenüber einem zweiten Einlassquerschnitt Q2 (siehe FIG 3), welcher sich auf einer Einlassseite E2 des zweiten Kühlkörpers 2 durch Einzelquerschnitte EQK2i der zugehörigen Kühlkanäle K2i des zweiten Kühlkörpers 2 zusammensetzt, der erste Einlassquerschnitt Q1 reduziert.

Zwischen dem ersten Kühlkörper 1 und dem zweiten Kühlkörper 2 ist gemäß FIG 3 ein Zwischenraum 3 angeordnet. Der Zwischenraum 3 ist gemäß FIG 2 mit einer Abdeckung 4 abgedeckt. Der Zwischenraum 3 und die Abdeckung 4 bilden eine Verwirbelungskammer. Der abgedeckte Zwischenraum 3 dient zur gleichmäßigen Verteilung des Kühlmediums 11 auf alle Kühlkanäle K2i des zweiten Kühlkörpers 2.

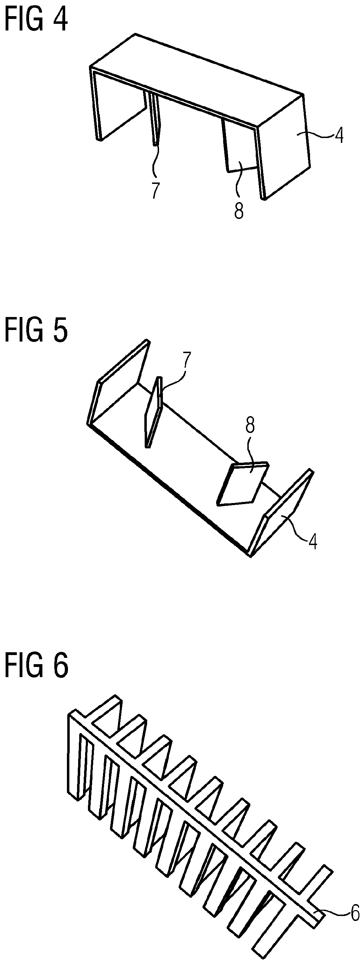

Die FIG 4 und FIG 5 zeigen die Abdeckung 4, wobei die Abdeckung 4 mit einem ersten Leitelement 7 und einem zweiten Leitelement 8 versehen ist.

Mit der FIG 6 ist das Abschottungsmittel in Form eines Kammes 6 dargestellt. Die einzelnen Kammelemente sind derart ausgestaltet, dass sie genau in den Zwischenraum von zwei Kühlrippen F passen und somit einen Kühlkanal abschotten können.

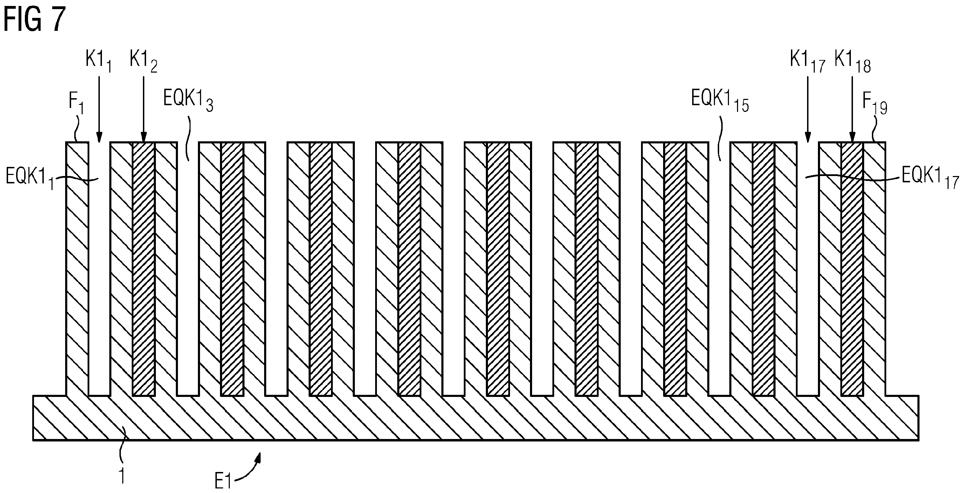

Mit der FIG 7 wird die Reduzierung des ersten Einlassquerschnittes Q1 gegenüber des zweiten Einlassquerschnittes Q2 veranschaulicht. Mit Blick auf die Kühlrippen F1,...,F19 des ersten Kühlkörpers 1 sind auch die jeweiligen Kühlkanäle $K1_1,K1_2,...,K1_{17},K1_{18}$ zu sehen. Mittels des Kamms 6, welcher in die Kühlkanäle K1i gesteckt ist, werden jeweils die Kühlkanäle K1i mit einem geraden Index verschlossen. Die Kühlkanäle K1i mit einem ungeraden Index bleiben offen. Für einen ersten Einlassquerschnitt Q1 ergibt sich demnach die Formel

$$Q1 = \sum_{1 \le i \le 9} EQK1(2i - 1)$$

und für einen zweiten dahinterliegenden Einlassquerschnitt des zweiten Kühlkörpers 2, bei welchem keiner der Kühlkanäle K2i verschlossen ist, ergibt sich für den zweiten Einlassquerschnitt Q2 die Formel

$$Q2 = \sum_{1 \le i \le 18} EQK2(i)$$

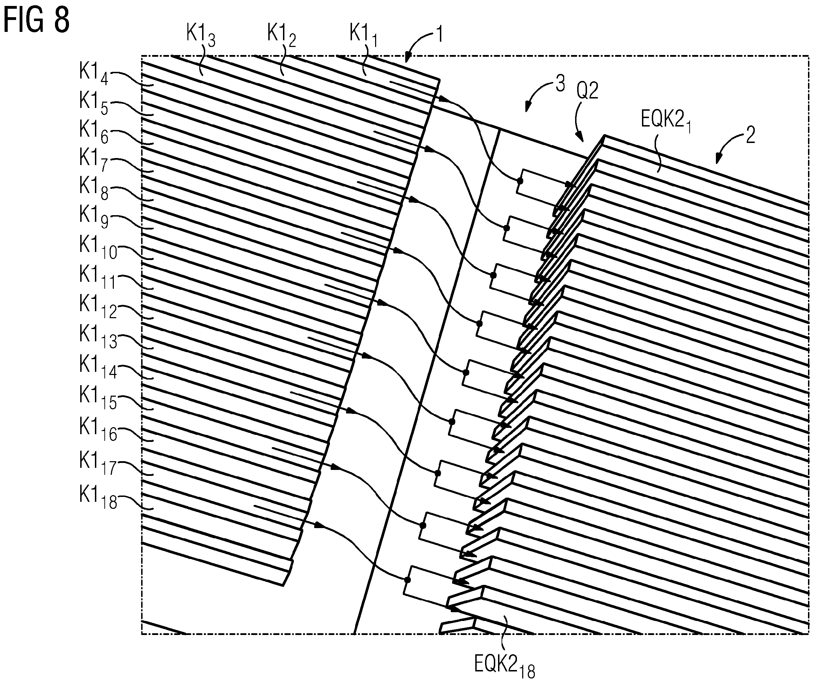

Mit der FIG 8 wird die erwähnte Verwirbelung der Strömung des Kühlmediums 11 in den Zwischenraum 3 verdeutlicht. Aufgrund des gesteckten Kammes 6 auf der Einlassseite E1 des ersten Kühlkörpers 1, kann nur aus den Kühlkanälen K1i mit ungeraden Index ein Kühlmediumteilstrom herausströmen. Die sich ergebenden neun ausströmenden Teilströme verteilen sich dann auf die Kühlkanäle K2i des zweiten Kühlkörpers 2, wobei dieser dann vollständig mit dem Kühlmedium 11, welches sich im ersten Kühlkörper noch nicht vollständig aufgeheizt hat, durchströmt werden.

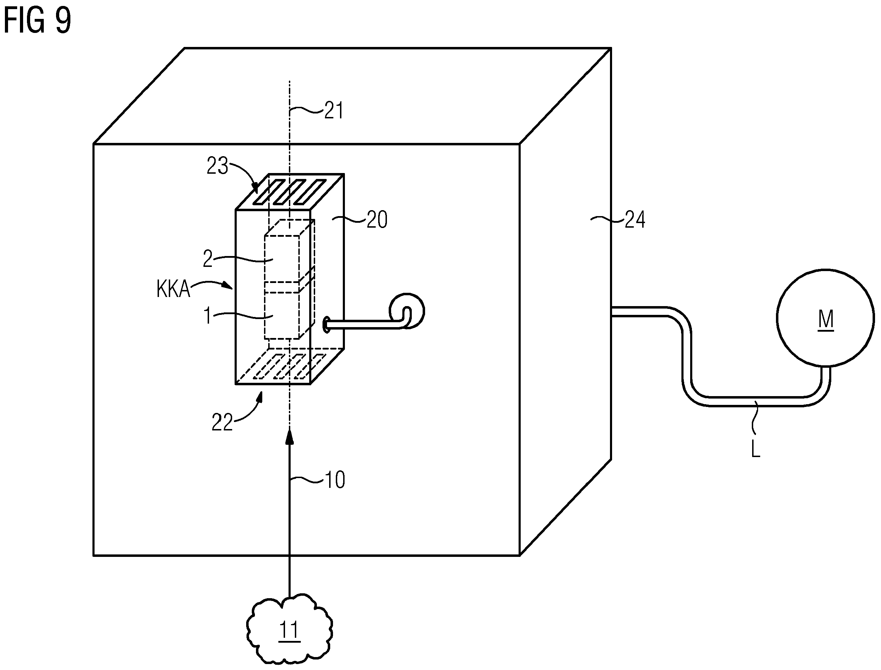

Gemäß FIG 9 ist eine Stromrichter-Anordnung 20 zur Versorgung einer elektrischen Maschine M in einem Schaltschrank 24 dargestellt. Eine Längsachse 21 der Stromrichter-Anordnung 20 bzw. der innen integrierten Kühlkörper-Anordnung KKA ist vertikal angeordnet und damit ist die Strömungsrichtung 10 durch die Stromrichter-Anordnung 20 parallel zur Längsachse 21 und ein Einlass 22 für das Kühlmedium 11 ist unten angeordnet und ein Auslass 23 für das Kühlmedium 11 ist oben angeordnet. Bei der Stromrichter-Anordnung 20 ist ein erster Kühlkörper 1 und ein weiterer, im Wesentlichen identischer Kühlkörper 2, zur Kühlung der Bauelemente hintereinander in Strömungsrichtung 10 angeordnet. Die Stromrichter-Anordnung 20 kann über eine Leitung L den Motor M steuern.

Durch Einsatz der erfindungsgemäßen Kühlkörper-Anordnung KKA, wobei bei dem ersten Kühlkörper 1 der Einlassquerschnitt Q1 durch ein Abschottungsmittel reduziert wurde, kann eine derartige Stromrichter-Anordnung 20 mit Vorteil in einer kleinen baulichen Abmessung ausgestaltet werden, weil es möglich ist, die hintereinander geschalteten Halbleiter-Bauelemente T1,...,T6 mit der erfindungsgemäßen Kühlkörper-Anordnung KKA effizient zu entwärmen.

**Patentansprüche**

1. Kühlkörper-Anordnung (KKA) für mehrere Halbleiter-Bauelemente (T1,..,T6) umfassend einen ersten Kühlkörper (1) und einen zweiten Kühlkörper (2) mit jeweils einer Bauelemente-Seite (BS1,BS2) und einer mit Kühlrippen (F) bestückten Kühlrippenseite (KR1,KR2), welche derart hintereinander angeordnet sind, dass ein Kühlmedium (11) in einer Strömungsrichtung (10) zunächst durch Kühlkanäle (K1i), welche durch die Kühlrippen (F) des ersten Kühlkörpers (1) gebildet sind, und dann durch Kühlkanäle (K2i), welche durch die Kühlrippen (F) des zweiten Kühlkörpers (2) gebildet sind, strömt, **dadurch gekennzeichnet, dass**

- ein erster Einlassquerschnitt (Q1), welcher sich auf einer Einlassseite (E1) des ersten Kühlkörpers (1) durch Einzelquerschnitte (EQK1i) der zugehörigen Kühlkanäle (Kli), des ersten Kühlkörpers (1) zusammensetzt, mittels eines Abschottungsmittels, welches die Kühlkanäle (K1i) auf der Einlassseite (E1) des ersten Kühlkörpers (1) zumindest teilweise abdeckt, gegenüber
- einem zweiten Einlassquerschnitt (Q2), welcher sich auf einer Einlassseite (E2) des zweiten Kühlkörpers (2) durch Einzelquerschnitte (EQK2i) der zugehörigen Kühlkanäle (K2i) des zweiten Kühlkörpers (2) zusammensetzt, reduziert ist.

2. Kühlkörper-Anordnung (KKA) nach Anspruch 1, wobei zwischen dem ersten Kühlkörper (1) und dem zweiten Kühlkörper (2) ein Zwischenraum (3) angeordnet ist, welcher mittels einer Abdeckung (4) abgedeckt ist, wobei der Zwischenraum (3) und die Abdeckung (4) eine Verwirbelungskammer bilden.

3. Kühlkörper-Anordnung (KKA) nach Anspruch 1 oder 2, wobei das Abschottungsmittel als ein Kamm (6) zum Einstecken in die Einlassseite (E1) des ersten Kühlkörper (1) ausgestaltet ist.

4. Kühlkörper-Anordnung (KKA) nach Anspruch 2 oder 3, wobei in dem Zwischenraum (3) Verwirbelungs- und/oder Leitelemente angeordnet sind.

5. Stromrichteranordnung (20) zur Versorgung einer elektrischen Maschine (M) umfassend eine Kühlkörper-Anordnung (KKA) für mehrere Halbleiter-Bauelemente (T1,...,T6), umfassend einen ersten Kühlkörper (1) und einen zweiten Kühlkörper (2) mit jeweils einer Bauelemente-Seite (BS1,BS2) und einer mit Kühlrippen (F) bestückten Kühlrippenseite (KR1,KR2), welche derart hintereinander angeordnet sind, dass ein Kühlmedium (11) in einer Strömungsrichtung (10) zunächst durch Kühlkanäle (Kli), welche durch die Kühlrippen (F) des ersten Kühlkörpers (1) gebildet sind, und dann durch Kühlkanäle (K2i), welche durch die Kühlrippen (F) des zweiten Kühlkörpers (2) gebildet sind, strömt, **dadurch gekennzeichnet, dass**

- ein erster Einlassquerschnitt (Q1), welcher sich auf einer Einlassseite (E1) des ersten Kühlkörper (1) durch Einzelquerschnitte (EQK1i) der zugehörigen Kühlkanäle (Kli), des ersten Kühlkörpers (1) zusammensetzt, mittels eines Abschottungsmittels, welches die Kühlkanäle (Kli), auf der Einlassseite (E1) des ersten Kühlkörper (1) zumindest teilweise abdeckt, gegenüber
- einem zweiten Einlassquerschnitt (Q2), welcher sich auf einer Einlassseite (E2) des zweiten Kühlkörpers (2) durch Einzelquerschnitte (EQK2i) der zugehörigen Kühlkanäle (K2i) des zweiten Kühlkörpers (2) zusammensetzt, reduziert ist.

6. Stromrichteranordnung (20) nach Anspruch 5, wobei zwischen dem ersten Kühlkörper (1) und dem zweiten Kühlkörper (2) ein Zwischenraum (3) angeordnet, welcher mittels einer Abdeckung (4) abgedeckt ist, wobei der Zwischenraum (3) und die Abdeckung (4) eine Verwirbelungskammer (5) bilden.

7. Stromrichteranordnung (20) nach Anspruch 5 oder 6, vorgesehen zum senkrechten Einbau in einen Schaltschrank (24), wobei eine Längsachse (21) der Kühlkörper-Anordnung (KKA) vertikal angeordnet ist und damit die Strömungsrichtung (10) durch die Stromrichter-Anordnung (20) parallel zur Längsachse (21) entsteht und ein Einlass (22) für ein Kühlmedium unten an der Einlassseite (E1) des ersten Kühlkörper (1) angeordnet ist und ein Auslass (23) für das Kühlmedium (11) oben über der der Einlassseite (E2) des zweiten Kühlkörpers (2) gegenüberliegenden Auslassseite angeordnet ist.

FIG 1

EP 3 989 689 A1

FIG 2

EP 3 989 689 A1

# FIG 3

FIG 4

FIG 5

FIG 6

FIG 7

FIG 8

$K1_3$  $K1_2$  $K1_1$  1

3  Q2

$EQK2_1$  2

$K1_4$
$K1_5$
$K1_6$
$K1_7$
$K1_8$
$K1_9$
$K1_{10}$
$K1_{11}$
$K1_{12}$
$K1_{13}$
$K1_{14}$
$K1_{15}$
$K1_{16}$
$K1_{17}$
$K1_{18}$

$EQK2_{18}$

EP 3 989 689 A1

FIG 9

EP 3 989 689 A1

**Europäisches Patentamt**
**European Patent Office**
**Office européen des brevets**

# EUROPÄISCHER RECHERCHENBERICHT

**Nummer der Anmeldung**

EP 20 20 3605

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2012/014066 A1 (MORINO MASAHIRO [JP] ET AL) 19. Januar 2012 (2012-01-19) * Absätze [0002], [0061] - [0121]; Abbildungen 1-19 * ----- | 1,2,4,6, 7 | INV. H05K7/20 |
| A | JP H07 249885 A (NEMIC LAMBDA KK) 26. September 1995 (1995-09-26) * das ganze Dokument * ----- | 1-7 | |
| A | US 2014/014308 A1 (WU KUAN-LUNG [TW] ET AL) 16. Januar 2014 (2014-01-16) * das ganze Dokument * ----- | 1-7 | |

**RECHERCHIERTE SACHGEBIETE (IPC)**

H05K

Der vorliegende Recherchenbericht wurde für alle Patentansprüche erstellt

| Recherchenort | Abschlußdatum der Recherche | Prüfer |
|---|---|---|
| Den Haag | 31. März 2021 | Kaluza, Andreas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 20 20 3605

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-03-2021

| Im Recherchenbericht angeführtes Patentdokument | Datum der Veröffentlichung | Mitglied(er) der Patentfamilie | Datum der Veröffentlichung |
|---|---|---|---|
| US 2012014066 A1 | 19-01-2012 | CN 102422413 A | 18-04-2012 |
| | | EP 2432012 A1 | 21-03-2012 |
| | | JP 5370481 B2 | 18-12-2013 |
| | | JP WO2010131317 A1 | 01-11-2012 |
| | | US 2012014066 A1 | 19-01-2012 |
| | | WO 2010131317 A1 | 18-11-2010 |
| JP H07249885 A | 26-09-1995 | KEINE | |
| US 2014014308 A1 | 16-01-2014 | CN 103547115 A | 29-01-2014 |
| | | US 2014014308 A1 | 16-01-2014 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0340520 B1